(19) Europäisches Patentamt
European Patent Office
Office européen des brevets

(11) **EP 2 521 424 A1**

(12) **EUROPEAN PATENT APPLICATION**
published in accordance with Art. 153(4) EPC

(43) Date of publication:
**07.11.2012 Bulletin 2012/45**

(51) Int Cl.:
*H05B 33/24* (2006.01)     *G09F 9/30* (2006.01)
*H01L 27/32* (2006.01)     *H01L 51/50* (2006.01)

(21) Application number: **10840981.4**

(22) Date of filing: **27.12.2010**

(86) International application number:
**PCT/JP2010/073515**

(87) International publication number:
**WO 2011/081125 (07.07.2011 Gazette 2011/27)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **28.12.2009 JP 2009297240**

(71) Applicant: **Sumitomo Chemical Company, Limited
Tokyo 104-8260 (JP)**

(72) Inventor: **TANAKA Shin-ya
Tsukuba-shi
Ibaraki 305-0047 (JP)**

(74) Representative: **Jackson, Martin Peter
J A Kemp
14 South Square
Gray's Inn
London WC1R 5JJ (GB)**

(54) **ORGANIC EL ELEMENT AND ORGANIC EL PANEL**

(57)    An organic EL element having a reflective layer, a first electrode, a light-emitting layer, a second electrode, and a semi-transparent reflective layer disposed in that order. The semi-transparent reflective layer comprises an optical adjustment layer formed of an insulating material which is provided so as to contact said second electrode on an opposite side from said light-emitting layer, and said optical adjustment layer has a refractive index at a wavelength of 450 nm of not less than 1.915, and has an optical film thickness, calculated as an arithmetic product of said refractive index and a film thickness, of not less than 70.174 nm and not more than 140.347 nm.

FIG. 1

| | |
|---|---|
| OPTICAL ADJUSTMENT LAYER | 19 |
| SECOND ELECTRODE | 18 |
| ELECTRON INJECTION LAYER | 17 |
| ELECTRON TRANSPORT LAYER | 16 |
| LIGHT-EMITTING LAYER | 15 |
| HOLE TRANSPORT LAYER | 14 |
| HOLE INJECTION LAYER | 13 |
| FIRST ELECTRODE | 12 |
| REFLECTIVE LAYER | 11 |
| SUBSTRATE | 10 |

EP 2 521 424 A1

## Description

TECHNICAL FIELD

The present invention relates to an organic EL element and an organic EL panel.
Priority is claimed on Japanese Patent Application No. 2009-297240, filed December 28, 2009, the content of which is incorporated herein by reference.

BACKGROUND ART

An organic EL element is configured by laminating a first electrode, a light-emitting layer, and a second electrode on a substrate in that order, and emits the desired light by injecting a hole and an electron into the light-emitting layer from the first electrode and the second electrode. The organic EL element can adjust light color by changing a light-emitting material used in the light-emitting layer. However, since luminous efficiencies of organic light-emitting materials vary greatly depending on materials, it is difficult to obtain a light-emitting material having desired color characteristics and luminance characteristics at the same time. To that end, NPL 1 discloses an organic EL element having a so-called microresonator structure in which a light-emitting layer is disposed between a reflective layer and a semi-transparent reflective layer and light of a desired color is extracted by amplifying light which has a resonance wavelength corresponding to an optical distance between the reflective layer and the semi-transparent reflective layer.

However, in the organic EL element having the microresonator structure, colors are different between a case where the organic EL element is seen from a front direction (normal direction of a substrate) and a case where the organic EL element is seen from a wide-angle direction (direction inclined obliquely to the normal direction of the substrate) and thus there is a problem in that it is difficult to obtain sufficient color reproduction over a wide range of viewing angles. That is, in the organic EL element having the microresonator structure, it is known that a wavelength of light when seen from the wide-angle direction is shifted to a short wavelength side and a display when seen from the wide-angle direction appears blue. Such a wavelength shift is noticeable particularly in blue light and a method of suppressing a wavelength shift of blue light becomes an important issue. For that reason, in Patent Document 1, by providing a color filter on a light exit side of an organic EL element, only light in a specific wavelength region is selectively transmitted, thereby suppressing a color change caused by such a wavelength shift.

CITATION LIST

PATENT DOCUMENT

[Patent Document 1] Japanese Patent Application Laid-Open No. 2005-129510

NON PATENT DOCUMENT

[Non Patent Document 1] "From the Basics to the Frontiers in the Research of Organic EL Materials and Devices", Dec. 16 and 17, 1993, Japan Society of Applied Physics, Molecular Electronics and Bioelectronics Division, JSAP Catalog Number: AP93 2376, p. 135-143.

DISCLOSURE OF INVENTION

PROBLEMS TO BE SOLVED BY THE INVENTION

However, in the method disclosed in Patent Document 1, since the color filter is additionally provided, the manufacturing processes of both an organic EL element and an organic EL panel become complicated and thus there is a problem in that it is difficult to reduce the entire size of the panel. In addition, most components of light emitted from an organic EL element are absorbed by the color filter and there is a problem in that brightness when seen from an oblique side deteriorates to a large degree. That is, in the organic EL element having the microresonator structure, the spectrum of emitted light has a sharp peak. Therefore, when the peak is shifted from a transparent wavelength region of the color filter, the luminance of light transmitted through the color filter deteriorates rapidly. With regard to light emitted from the front direction, the luminance of light after transmission through the color filter deteriorates to a large degree.

The present invention has been made in consideration of the above-described circumstances of the related art, and provides an organic EL element and an organic EL panel which are capable of obtaining sufficient color reproduction over a wide range of viewing angles without providing a color filter.

MEANS TO SOLVE THE PROBLEMS

According to the present invention, an organic EL element is provided having a reflective layer, a first electrode, a light-emitting layer, a second electrode which is an anode or a cathode, and a semi-transparent reflective layer disposed in that order, wherein said semi-transparent reflective layer comprises an optical adjustment layer formed of an insulating material which is provided so as to contact said second electrode on an opposite side from said light-emitting layer, and said optical adjustment layer has a refractive index at a wavelength of 450 nm of not less than 1.915, and has an optical film thickness, calculated as an arithmetic product of said refractive index and a film thickness, of not less than 70.174 nm and not more than 140.347 nm.

That is, the organic EL element of the present invention includes a microresonator structure and the optical adjustment layer having desired optical characteristics is provided therein. By adjusting a refractive index and an optical film thickness of the optical adjustment layer, a color change in the wide-angle direction is suppressed.

The relationship between a refractive index and a film thickness of the optical adjustment layer; and a color change in the wide-angle direction (in this specification, sometimes referred to as viewing angle characteristics) will be described in detail with reference to embodiments which will be described below. According to a simulation which was conducted by the present inventors using the Finite Difference Time Domain Method (FDTD method), the greater the refractive index of the optical adjustment layer, the smaller the color change of light when observed from the wide-angle direction, and by designing an optical film thickness in a desired range, this effect can be exhibited sufficiently. The effect of suppressing a color change using the optical adjustment layer is not determined solely by an optical film thickness of the optical adjustment layer. Unless the optical adjustment layer has a refractive index of not less than a predetermined refractive index, such an effect is not exhibited sufficiently. That is, unless both of a refractive index and an optical film thickness of the optical adjustment layer are designed appropriately, a color change in the wide-angle direction is not suppressed, and even if suppressed, the effect is limited.

In the present invention, "a color change is suppressed" means that a value of Max$\Delta$u'v', calculated in a method which will be described in an embodiment below, is not more than 0.081. If a value of Max$\Delta$u'v' falls within this range, practically sufficient viewing angle characteristics can be obtained even with the strictest evaluation criteria required for an organic EL display and the like.

It is preferable that a refractive index of said optical adjustment layer be not less than 2.078. With this configuration, a value of Max$\Delta$u'v' can be set to be not more than 0.07. In addition, when a refractive index of the optical adjustment layer is not less than 2.078 and an optical film thickness of the optical adjustment layer is not more than 123.49 nm, a value of Max$\Delta$u'v' can be set to be not more than 0.061. With this configuration, an organic EL element in which a color change is further reduced can be provided.

Said optical adjustment layer can be formed of one material selected from the group consisting of silicon monoxide (SiO), tungsten oxide ($WO_3$), zinc sulfide (ZnS), N,N'-bis(naphthalen-1-yl)-N,N'-bis(phenyl)-benzidine (NPD), and titanium dioxide ($TiO_2$). Since these materials have refractive indices of not less than 1.915, an effect of suppressing a color change is high.

It is preferable that an optical distance between said reflective layer and said semi-transparent reflective layer be set so as to possess a resonance wavelength in a blue light wavelength region. As described above, in the organic EL element having the microresonator structure, such a wavelength shift is noticeable particularly in blue light. Therefore, when the present invention is applied to an organic EL element which emits blue light, the effect of the present invention is exhibited fully.

It is preferable that said light-emitting layer be formed of a blue light-emitting material.

An organic EL panel of the present invention includes a plurality of the above-described organic EL elements of the present invention aligned on a substrate. With this configuration, an organic EL panel capable of obtaining sufficient color reproduction over a wide range of viewing angles can be provided.

It is preferable that a plurality of organic EL elements which emit light of mutually different colors from respective said semi-transparent reflective layers be provided on said substrate and that refractive indices and optical film thicknesses of said optical adjustment layers of said plurality of organic EL elements be equal. With this configuration, since optical adjustment layers can be formed on respective organic EL elements through a common process, the manufacturing process can be simplified.

EFFECT OF THE INVENTION

] According to the present invention, an organic EL element in which a color change over a wide range of viewing angles is reduced without using a color filter can be provided. Therefore, as compared to a structure of Patent Document 1 using a color filter, a bright display can be realized with less power consumption. In addition, when a color filter is used, it is necessary that the color filter be bonded while aligning the color filter with the position of an organic EL element. However, in the present invention, since an optical adjustment layer can be formed along with a process of forming an organic EL element, a process is simple and manufacturing is easy. Therefore, according to the present invention, a small and inexpensive organic EL element and an organic EL panel can be provided which have excellent color reproduction over a wide range of viewing angles.

BRIEF DESCRIPTION OF THE DRAWINGS

FIG. 1 is a cross-sectional view schematically illustrating a configuration of an organic EL element.
FIG. 2 is a diagram illustrating measurement results of refractive indices of materials constituting an optical adjustment layer.
FIG. 3 is a diagram illustrating measurement results of extinction coefficients of materials constituting an optical adjustment layer.
FIG. 4 is a diagram illustrating fluorescence spectra of a red organic light-emitting material, a green organic light-emitting material, and a blue organic light-emitting material which are used for a simulation.
FIG. 5 is a diagram illustrating the relationship between materials used for an optical adjustment layer and viewing angle characteristics.

MODE FOR CARRYING OUT THE INVENTION

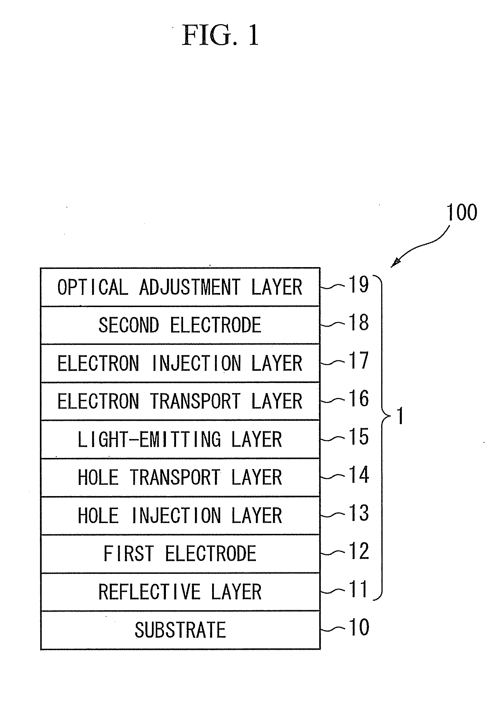

FIG. 1 is a cross-sectional view illustrating an organic EL element 1 and an organic EL panel 100 according to an embodiment of the present invention. The organic EL element 1 is an organic EL element having a so-called microresonator structure in which a light-emitting layer 15 is disposed between a reflective layer 11 and an optical adjustment layer 19 and, among light rays emitted from the light-emitting layer 15, a light ray having a resonance wavelength corresponding to an optical distance between the reflective layer 11 and the optical adjustment layer 19 is amplified and emitted from the optical adjustment layer 19.

The optical adjustment layer 19 functions as a semi-transparent reflective layer in which a part of light rays emitted from the light-emitting layer 15 passes therethrough and other light rays are reflected toward the light-emitting layer 11. The semi-transparent reflective layer only needs to include the optical adjustment layer 19 formed of an insulating material which is provided so as to contact a second electrode 18 including a cathode and an anode, and may include a protective layer which protects the surface of the optical adjustment layer 19. That is, the optical adjustment layer 19 is a layer which is disposed in a position closest to the second electrode side among single or multiple layers disposed above the second electrode 18. If needed, single or multiple layers such as a protective layer are formed above the optical adjustment layer 19.

The organic EL panel 100 includes single or a plurality of organic EL elements 1 aligned on a substrate 10. The organic EL panel 100 is used as lighting equipment such as organic EL lighting devices and display panels such as organic EL displays.

The substrate 10 only needs to be one which is not chemically changed when electrodes 12 and 18 are formed or organic layers (for example, the light-emitting layer 15) are formed thereon, and is configured using a substrate formed of, for example, glass, plastic, polymer film, or silicon, a substrate obtained by laminating the above materials, or the like. In addition, the substrate 10 may be one in which a circuit layer including TFT, wirings, and the like is formed on a substrate formed of glass or the like.

The organic EL element 1 includes at least one of light-emitting layers formed of low-molecular and/or polymer organic light-emitting materials between the pair of electrodes 12 and 18. Examples of a constituent in the vicinity of the light-emitting layer include a layer disposed between the second electrode 18 and the light-emitting layer 15 and a layer disposed between the first electrode 12 and the light-emitting layer 15, as layers other than the first electrode 12, the second electrode 18, and the light-emitting layer 15.

Examples of the layer disposed between the second electrode 18 and the light-emitting layer 15 include an electron injection layer 17, an electron transport layer 16, and a hole block layer. The electron injection layer 17 and the electron transport layer 16 are layers having a function of improving electron injection efficiency from the second electrode 18 to the light-emitting layer 15. When the electron injection layer 17 or the electron transport layer 16 has a function of blocking hole transport, these layers 17 and 16 may be referred to as hole block layers. Whether these layers have a function of blocking hole transport or not can be examined by, for example, preparing an element through which only hole current flows and checking a block effect with the reduction of a current value thereof.

Examples of the layer disposed between the first electrode 12 and the light-emitting layer 15 include a hole injection layer 13, a hole transport layer 14 and an electron block layer. The hole injection layer 13 and the hole transport layer 14 are layers having a function of improving hole injection efficiency from the first electrode 11. When the hole injection layer 13 or the hole transport layer 14 has a function of blocking electron transport, these layers 13 and 14 may be referred to as electron block layers. Whether these layers have a function of blocking electron transport or not can be examined by, for example, preparing an element through which only electron current flows and checking a block effect with the reduction of a current value thereof.

Here, the hole transport layer 14 is a layer having a function of transporting a hole and the electron transport layer 16 is a layer having a function of transporting an electron. In addition, the electron transport layer 16 and the hole transport layer 14 are collectively referred to as a charge transport layer. The light-emitting layer 15, the hole transport layer 14, and the electron transport layer 16 may be formed as two or more layers, respectively. In addition, among the charge transport layers 14 and 16 which are provided adjacent to the electrodes 12 and 18, layers having a function of improving charge injection efficiency from the electrode 12 and 18 and having an effect of lowering drive voltage of an element may be generally referred to as charge injection layers (hole injection layer 13 and electron injection layer 17) in particular.

In order to improve the adhesion between the electrodes 12 and 18 and the light-emitting layer and to improve charge injection from the electrode 12 and 18, the charge injection layers 13 and 17 or an insulating layer having a film thickness of not more than 2 nm may be provided adjacent to the electrode 12 and 18. In addition, for example, in order to improve adhesion and prevent merging at an interface, a thin buffer layer may be interposed at interfaces between the charge transport layers 14 and 16 and the light-emitting layer 15. The order and number of layers laminated and the thicknesses of the respective layers can be appropriately set in consideration of luminous efficiency and element lifetime.

As the first electrode 12, for example, a transparent electrode or a semi-transparent electrode formed of a metal oxide, a metal sulfide, or a metal thin film having high electric conductance can be used,. Among these, an electrode having high transmittance is preferably used and can be appropriately selected and used according to organic layers (such as a hole injection layer) adjacent thereto.
Specifically, a film (for example, NESA) which is prepared using conductive glass formed of indium oxide, zinc oxide, tin oxide, or a complex thereof such as indium tin oxide (ITO) or indium zinc oxide; gold; platinum; silver; copper; and the like are used, and ITO, indium zinc oxide, and tin oxide are preferable. Examples of a preparation method include a vacuum deposition method, a sputtering method, an ion plating method, and a plating method. In addition, as the first electrode 12, an organic transparent conductive film such as polyaniline or derivatives thereof and polythiophene or derivatives thereof may be used.

The film thickness of the first electrode 12 can be appropriately selected in consideration of light permeability and electric conductance, for example from 10 nm to 10 $\mu$m, preferably from 20 nm to 1 $\mu$m, and further preferably from 50 nm to 500 nm.

As the reflective layer 11, a conductive film with high reflectance such as aluminum (Al) or silver (Ag) or a dielectric multilayer film with high reflectance in which two or more conductive multilayer film having different refractive indices are alternately laminated can be used. The reflective layer 11 can be omitted when the first electrode 12 is formed of a conductive film with high reflectance such as aluminum (Al) or silver (Ag). In this case, the first electrode 12 functions as a reflective layer.

The hole injection layer 13 can be disposed between the first electrode 12 and the hole transport layer 14 or between the first electrode 12 and the light-emitting layer 15. Examples of a material which forms the hole injection layer 13 include phenyl amines, star-burst amines, phthalocyanines, oxides such as vanadium oxide, molybdenum oxide, ruthenium oxide, and aluminum oxide, amorphous carbon, polyaniline, and polythiophene derivatives.

Examples of a material which constitutes the hole transport layer 14 include polyvinylcarbazole or derivatives thereof; polysilane or derivatives thereof; polysiloxane derivatives having an aromatic amine at a side chain or main chain; pyrazoline derivatives; arylamine derivatives; stilbene derivatives; triphenyl diamine derivatives; polyaniline or derivatives thereof; polythiophene or derivatives thereof; polyarylamine or derivatives thereof; polypyrrole or derivatives thereof; poly(p-phenylene vinylene) or derivatives thereof; and poly(2,5-thienylene vinylene) or derivatives thereof.

Among these, as a hole transport material used for the hole transport layer 14, polymer hole transport materials such as polyvinylcarbazole or derivatives thereof; polysilane or derivatives thereof; polysiloxane derivatives having an aromatic amine at a side chain or main chain; polyaniline or derivatives thereof; polythiophene or derivatives thereof; polyarylamine or derivatives thereof; poly(p-phenylene vinylene) or derivatives thereof; and poly(2,5-thienylene vinylene) or derivatives thereof are preferable and polyvinylcarbazole or derivatives thereof; polysilane or derivatives thereof; and polysiloxane derivatives having an aromatic amine at a side chain or main chain are further preferable. In the case of a low-molecular hole transparent material, it is preferable to use it in a state of being dispersed in a polymer binder.

The light-emitting layer 15 includes organic materials (a low-molecular compound and a polymer compound) which mainly emit fluorescence or phosphorescence. The light-emitting layer 15 may include a dopant material. Light-emitting-layer-forming materials which can be used in the present invention are as follows, for example.

(Light-Emitting-Layer-Forming Material 1: Pigment-Based Material)

Examples of a pigment-based material include cyclopentamine derivatives, tetraphenyl butadiene derivative compounds, triphenylamine derivatives, oxadiazole derivatives, pyrazolo-quinoline derivatives, distyrylbenzene derivatives, distyrylarylene derivatives, pyrrole derivatives, thiophene ring-containing compounds, pyridine ring-containing compounds, perinone derivatives, perylene derivatives, oligothiophene derivatives, trifumanyl amine derivatives, oxadiazole dimers, and pyrazoline dimers.

(Light-Emitting-Layer-Forming Material 2: Metal Complex-Based Material)

Examples of a metal complex-based material include a metal complex such as iridium complex or platinum complex in which light is emitted in a triplet excited state; and a metal complex such as aluminum quinolinol complex, benzoquinolinol beryllium complex, benzoxazolyl zinc complex, benzothiazole zinc complex, azomethyl zinc complex, porphyrin zinc complex, or europium complex including Al, Zn, Be or the like or rare earth metal such as Tb, Eu or Dy as a central metal and including a structure of oxadiazole, thiadiazole, phenylpyridine, phenylbenzimidazol, or quinoline as a ligand.

(Light-Emitting-Layer-Forming Material 3: Polymer-Based Material)

Examples of a polymer-based material include polyparaphenylene vinylene derivatives, polythiophene derivatives, polyparaphenylene derivatives, polysilane derivatives, polyacetylene derivatives, polyfluorene derivatives, polyvinylcarbazole derivatives, and polymers of the above pigment-based materials and the above metal complex-based materials.

Examples of materials which emit blue light among the above light-emitting-layer-forming materials include distyrylarylene derivatives, oxadiazole derivatives, polymers thereof, polyvinylcarbazole derivatives, poly(paraphenylene) derivatives, and polyfluorene derivatives. Among these, polymer materials such as polyvinylcarbazole derivatives, poly(paraphenylene) derivatives, and polyfluorene derivatives are preferable.

Examples of materials which emit green light among the above light-emitting-layer-forming materials include quinacridone derivatives, coumarin derivatives, polymers thereof, polyparaphenylene vinylene derivatives, and polyfluorene derivatives. Among these, polymer materials such as polyparaphenylene vinylene derivatives, and polyfluorene derivatives are preferable.

In addition, examples of materials which emit red light among the above light-emitting-layer-forming materials include coumarin derivatives, thiophene ring-containing compounds, polymers thereof, polyparaphenylene vinylene derivatives, polythiophene derivatives, and polyfluorene derivatives. Among these, polymer materials such as polyparaphenylene vinylene derivatives, polythiophene derivatives, and polyfluorene derivatives are preferable.

(Light-Emitting-Layer-Forming Material 4: Dopant Material)

In order to improve luminous efficiency and to change an emission wavelength, a dopant may be added to the light-emitting layer. Examples of such a dopant include perylene derivatives, coumarin derivatives, rubrene derivatives, quinacridone derivatives, squalium derivatives, porphyrin derivatives, styryl-based pigments, tetracene derivatives, pyrazolone derivatives, decacyclene, and phenoxazone.

As a material which forms the electron transport layer 16, well-known materials can be used, and examples thereof include oxadiazole derivatives, anthraquinodimethane or derivatives thereof, benzoquinone or derivatives thereof, naphthoquinone or derivatives thereof, anthraquinone or derivatives thereof, tetracyano-anthraquino-dimethane or derivatives thereof, fluorenone derivatives, diphenyl dicyanoethylene or derivatatives thereof, diphenoquinone or derivatatives thereof, 8-hydroxyquinoline or metal complexes of derivatives thereof, polyquinoline or derivatives thereof, polyquinoxaline or derivatives thereof, and polyfluorene or derivatives thereof.

Among these, oxadiazole derivatives, benzoquinone or derivatives thereof, anthraquinone or derivatives thereof, 8-hydroxyquinoline or metal complexes of derivatives thereof, polyquinoline or derivatives thereof, polyquinoxaline or derivatives thereof, and polyfluorene or derivatives thereof are preferable, and 2-(4-biphenylyl)-5-(4-tert-butylphenyl)-1,3,4-oxadiazole, benzoquinone, anthraquinone, tris(8-quinolinol)aluminum, and polyquinoline are further preferable.

As described above, the electron injection layer 17 is disposed between the electron transport layer 16 and the second electrode 18 or between the light-emitting layer 15 and the second electrode 18. As the electron injection layer 17, according to the kind of the light-emitting layer 15, the electron injection layer 17 can be provided including a single-layer structure of a Ca layer or an electron injection layer having a laminated structure of a Ca layer and a layer which is formed of one or two or more kinds selected from the group consisting of metals other than Ca belonging to IA group and IIA group of the periodic system and having a work function of 1.5 eV to 3.0 eV; and oxides, halides, and carbonates of the metals. Examples include metals belonging to IA group of the periodic system and having a work function of 1.5 eV to 3.0 eV; and oxides, halides, and carbonates of the metals include lithium, lithium fluoride, sodium oxide, lithium oxide, and lithium carbonate. Examples include metals other than Ca belonging to IIA group of the periodic system and having a work function of 1.5 eV to 3.0 eV; and oxides, halides, and carbonates of the metals include strontium, magnesium oxide, magnesium fluoride, strontium fluoride, barium fluoride, strontium oxide, and magnesium carbonate.

As the second electrode 18, a transparent electrode or a semi-transparent electrode can be used, and examples thereof include metals, graphite or graphite intercalation compounds, inorganic semiconductors such as ZnO (Zinc oxide), conductive transparent electrodes such as ITO (indium tin oxide) and IZO (indium zinc oxide), and metal oxides such as strontium oxide and barium oxide. Examples of metals include alkali metal such as lithium, sodium, potassium, rubidium, or cesium; alkali earth metal such as beryllium, magnesium, calcium, strontium, or barium; transition metal such as gold, silver, platinum, copper, manganese, titanium, cobalt, nickel, or tungsten; tin, aluminum, scandium, vanadium, zinc, yttrium, indium, cerium, samarium, europium, terbium, or ytterbium; and an alloy of two or more kinds thereof. Examples of the alloy include magnesium-silver alloy, magnesium-indium alloy, magnesium-aluminum alloy, indium-silver alloy, lithium-aluminum alloy, lithium-magnesium alloy, lithium-indium alloy, and calcium-aluminum alloy. In addition a cathode may have a laminated structure of two or more layers. An example thereof includes a laminated structure of metals, metal oxides, fluorides, and alloys thereof which are described above, and metals such as aluminum, silver, and chrome.

The optical adjustment layer 19 is formed to cover an exposed side of the second electrode 18 above the substrate 10 (on an opposite side from the light-emitting layer 15). The exposed side of the second electrode 18 above the substrate 10 is a light exit side of the second electrode 18 where light is emitted from light-emitting layer 15, and the optical adjustment layer 19 contacts the light exit side of the second electrode 18.

As a material which forms the optical adjustment layer 19, an insulating material having a high refractive index and a low extinction coefficient may be used. Examples of inorganic materials include metal oxide, metal complex oxide, metal sulfide, and metal complex sulfide, examples of metal oxide include titanium oxide ($TiO_2$), tungsten oxide ($WO_3$), aluminum oxide ($Al_2O_3$), and silicon monoxide (SiO), and an example of metal sulfide includes zinc sulfide (ZnS). In addition at least one material selected from the group consisting of the above materials may be used alone or a plurality of materials may be used in combination.

Even when an organic material is used as a material which forms the optical adjustment layer 19, an insulating material having a high refractive index and a low extinction coefficient can be preferably used. An example thereof includes N,N'-bis(naphthalen-1-yl)-N,N'-bis(phenyl)-benzidine (NPD). An organic titanium compound may be used. In addition, a material in which an organic material which forms the optical adjustment layer 19 is used as a base material and metal oxide particles having a high refractive index are dispersed therein, can be preferably used.

When a material with a high refractive index which is mixed in the optical adjustment layer 19 is in the form of particles, it is preferable that the particles be uniformly dispersed in the layer. The material with a high refractive index which is mixed to the organic layer in the form of particles may be dispersed only in the layer such that an interface of the organic layer be not disarranged or may be dispersed such that the material protrude toward the outside of the layer from the interface to form convex and concave portions. By forming the convex and concave portions on the interface of the organic layer, a refractive index is further adjusted, which is preferable from the viewpoint of improving the overall controllability of refractive index.

Examples of a method of forming the optical adjustment layer 19 which is formed of the group of the above materials include a vacuum deposition method, electron beam method, ion plating method, sputtering method, and plating method, and when wet film-formation can be used for the material, a spin-coating method, a barcode method, a printing method, or the like is used.

In addition, in the organic EL element 1 illustrated in FIG. 1, the first electrode 12 is used as an anode and the second electrode 18 is used as a cathode, but these may be arranged reversely. That is, from the substrate side, a cathode, an electron injection layer, an electron transport layer, a light-emitting layer, a hole transport layer, a hole injection layer, and an anode may be disposed in that order. In addition, in the organic EL element 1 illustrated in FIG. 1, from the substrate 10 side, the reflective layer 11, the light-emitting layer 15, and the optical adjustment layer 19 are disposed in that order and a top emission structure in which light is extracted from the side opposite the substrate 10 is adopted. However, from the substrate 10 side, the optical adjustment layer, the light-emitting layer, and the reflective layer are disposed in that order and a bottom emission structure in which light is extracted from the substrate 10 side is adopted. Examples

Hereinafter, examples of the present invention will be described. Examples described below are preferred examples for describing the present invention and do not limit the present invention.

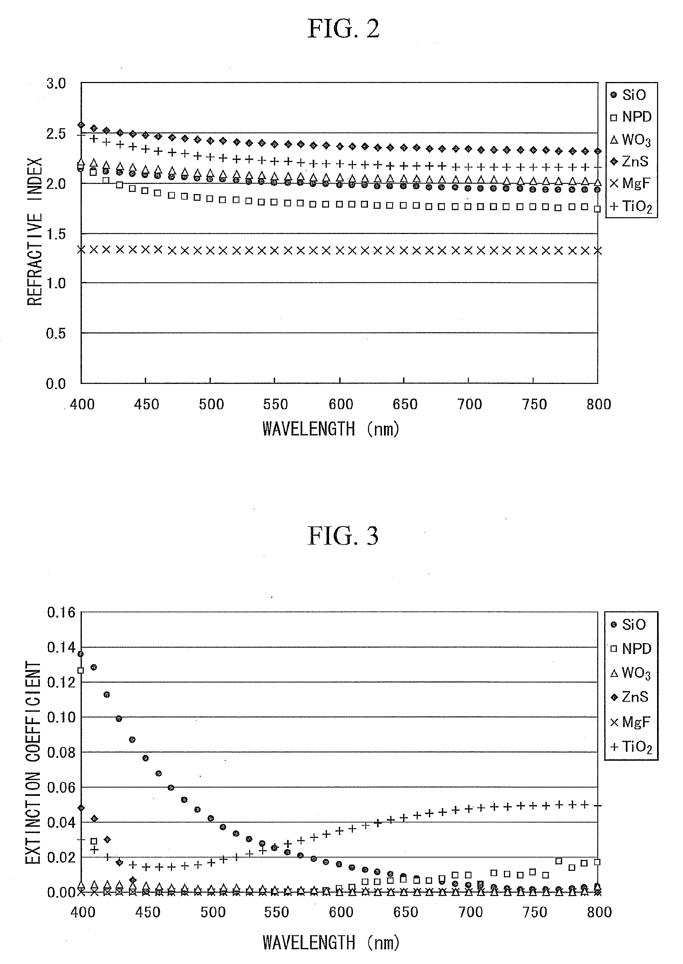

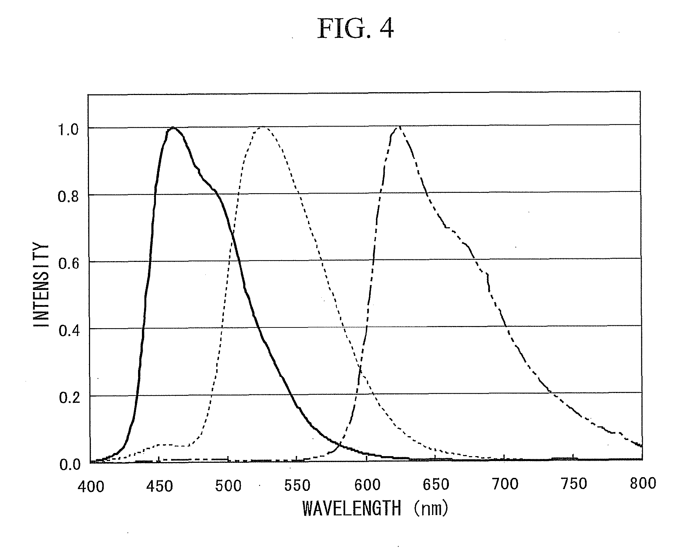

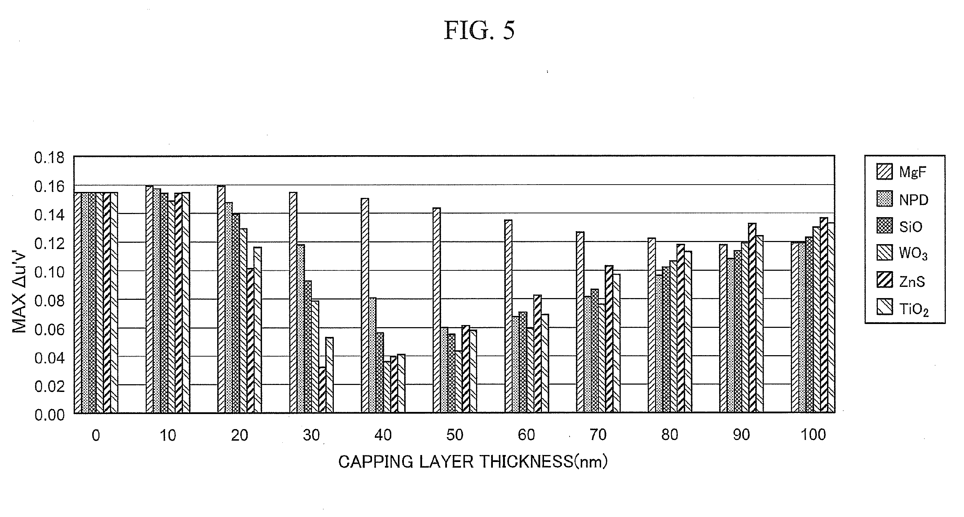

FIGs. 2 and 3 are diagrams illustrating the results of measuring refractive indices and extinction coefficients of materials constituting the optical adjustment layer, which are used in the present examples, at a wavelength of 450 nm using an ellipsometer (manufactured by J.A Woolam Co., Inc., M-2000). FIG. 4 is a diagram illustrating the measurement results of fluorescence spectra of a red organic light-emitting material, a green organic light-emitting material, and a blue organic light-emitting material which constitute the light-emitting layer of the organic EL element. FIG. 5 is a diagram illustrating the evaluation results of viewing angle characteristics of the organic EL element. For the evaluation of viewing angle characteristics, a Finite Difference Time Domain Method (FDTD method), which is a method of electromagnetic wave analysis, was used. SETFOS manufactured by Fluxim AG was used as simulation software. Optic constants and emission spectra of respective materials were input to this software for FDTD simulation.

In the present example, as materials which form the optical adjustment layer, silicon monoxide (SiO), tungsten oxide ($WO_3$), zinc sulfide (ZnS), N,N'-bis(naphthalen-1-yl)-N,N'-bis(phenyl)-benzidine (NPD), magnesium fluoride (MgF), and titanium dioxide ($TiO_2$) were used. Samples, which were obtained by changing actual film thicknesses of the above materials at intervals of 10 nm in a range of 10 nm to 100 nm, were set to Configuration Example B1 to B60, G1 to G60, and R1 to R60, and viewing angle characteristics were evaluated.

In the cases of Configuration Examples B1 to B60, the blue light-emitting material was applied to the light-emitting layer and an optical distance between the reflective layer and the semi-transparent reflective layer was set so as to possess a resonance wavelength in a blue light wavelength region. In the cases of Configuration Examples G1 to G60, the green light-emitting material was applied to the light-emitting layer and an optical distance between the reflective layer and the semi-transparent reflective layer was set so as to possess a resonance wavelength in a green light wavelength region. In the cases of Configuration Examples R1 to R60, the red light-emitting material was applied to the light-emitting layer and an optical distance between the reflective layer and the semi-transparent reflective layer was set so as to possess a resonance wavelength in a red light wavelength region. Configuration Example B1 to B60, G1 to G60, and R1 to R60, have the same configuration, except that light-emitting layers were formed of different light-emitting materials with different actual film thicknesses and optical adjustment layers were formed of different light-emitting materials with different actual film thicknesses.

In Configuration Examples B1 to B60, configurations are the same except for the optical adjustment layer. That is, on a glass substrate, a 100 nm-thick Ag electrode and a 15 nm-thick ITO electrode were laminated as the first electrode; a 15 nm-thick poly(3,4-ethylenedioxythiophene)/poly(styrenesulfonate) (referred to as PEDOT) was laminated as the hole injection layer; a 20 nm-thick hole transport material (manufactured by Sumation Co.; Ltd., trade name: HT1100) was laminated as the hole transport layer; a 45 nm-thick blue light-emitting material (manufactured by Sumation Co., Ltd., trade name: Lumation BP361) was laminated as a blue light-emitting layer; a 5 nm-thick Ba electrode and a 20 nm-thick Ag electrode were laminated as the second electrode. In addition, on the surface of the second electrode, an optical adjustment layer formed of any one of SiO, $WO_3$, ZnS, NPD, MgF, and $TiO_2$ was laminated in any one of film thicknesses of 10 nm, 20 nm, 30 nm, 40 nm, 50 nm, 60 nm, 70 nm, 80 nm, 90 nm, and 100 nm. In this way, organic EL elements according to Configuration Examples B1 to B60 were obtained. In addition, the first electrode also serves as the reflective layer.

In Configuration Examples G1 to G60, configurations are the same except for the optical adjustment layer. That is, on a glass substrate, a 100 nm-thick Ag electrode and a 15 nm-thick ITO electrode were laminated as the first electrode; a 15 nm-thick poly(3,4-ethylenedioxythiophene)/poly(styrenesulfonate) (referred to as PEDOT) was laminated as the hole injection layer; a 20 nm-thick hole transport material (manufactured by Sumation Co., Ltd., trade name: HT1100) was laminated as the hole transport layer; a 65 nm-thick green light-emitting material (manufactured by Sumation Co., Ltd., trade name: Lumation G1304) was laminated as a green light-emitting layer; a 5 nm-thick Ba electrode and a 20 nm-thick Ag electrode were laminated as the second electrode. In addition, on the surface of the second electrode, an optical adjustment layer formed of any one of SiO, $WO_3$, ZnS, NPD, MgF, and $TiO_2$ was laminated in any one of film thicknesses of 10 nm, 20 nm, 30 nm, 40 nm, 50 nm, 60 nm, 70 nm, 80 nm, 90 nm, and 100 nm. In this way, organic EL elements according to Configuration Examples G1 to G60 were obtained. In addition, the first electrode also serves as the reflective layer.

In Configuration Examples R1 to R60, configurations are the same except for the optical adjustment layer. That is, on a glass substrate, a 100 nm-thick Ag electrode and a 15 nm-thick ITO electrode were laminated as the first electrode; a 15 nm-thick poly(3,4-ethylenedioxythiophene)/poly(styrenesulfonate) (referred to as PEDOT) was laminated as the hole injection layer; a 20 nm-thick hole transport material (manufactured by Sumation Co., Ltd., trade name: HT1100) was laminated as the hole transport layer; a 78 nm-thick red light-emitting material (manufactured by Sumation Co., Ltd., trade name: Lumation RP158) was laminated as a red light-emitting layer; a 5 nm-thick Ba electrode and a 20 nm-thick Ag electrode were laminated as the second electrode. In addition, on the surface of the second electrode, an optical adjustment layer formed of any one of SiO, $WO_3$, ZnS, NPD, MgF, and $TiO_2$ was laminated in any one of film thicknesses of 10 nm, 20 nm, 30 nm, 40 nm, 50 nm, 60 nm, 70 nm, 80 nm, 90 nm, and 100 nm. In this way, organic EL elements according to Configuration Examples R1 to R60 were obtained. In addition, the first electrode also serves as the reflective layer.

In the organic EL elements of Configuration Examples above, the luminance of light extracted from a front direction (normal direction of the substrate) and emission spectra thereof at respective viewing angles, which range from 0° to 85° at intervals of 5°, were calculated using the FDTD method. As a result, chromaticity coordinates (x, y) of xy Chromaticity Diagram (CIE 1931) were calculated from the emission spectra. With regard to dependency of chromaticity on viewing angle, chromaticity coordinates (x, y) at respective viewing angles were converted to chromaticity coordinates (u', v') of uv Chromaticity Diagram (CIE 1976) using (Expression 1); chromaticity differences Δu'v', which are the distances between chromaticity coordinates $(u'_1, v'_1)$ and $(u'_2, v'_2)$ of uv Chromaticity Diagram for two viewing angles shifted by 5°, for example, 5° and 10°, 10° and 15°, and 15° and 20°, were calculated using (Expression 2); and the maximum chromaticity difference MaxΔu'v' was evaluated for dependency of chromaticity on viewing angle.

$$(\text{Expression 1})$$

$$u' = 4x/(-2x+12y+3)$$

$$v' = 6y/(-2x+12y+3)$$

$$(\text{Expression 2})$$

$$\Delta u'v' = \{(u'_1-u'_2)^2+(v'_1-v'_2)^2\}^{1/2}$$

FIG. 5 is a diagram illustrating the results of examining the relationship between the materials used for the optical adjustment layer and MaxΔu'v' in Configuration Examples B1 to B60. In FIG. 5 the horizontal axis represents actual film thicknesses of the optical adjustment layers and the vertical axis represents values of MaxΔu'v'. Tables 1 to 6 collectively show refractive indices and optical film thicknesses of the optical adjustment layers, luminance ratios of light emitted from the front direction, display colors (coordinates of chromaticity diagram CIEx and CIEy) in the front direction (at a viewing angle of 0°), and MaxΔu'v', in Configuration Examples B1 to B60, G1 to G60, and R1 to R60. Here, "refractive indices" represent refractive index at a wavelength of 450 nm and "luminance ratios" represent luminance ratios in a case where the luminance values of the organic EL elements according to Configuration Examples B0, G0, and R0, which are not provided with an optical adjustment layer, are 1.

[Table 1]

| Configuration Example No. | Optical Adjustment Layer | Refractive Index at 450 nm | Actual Film Thickness | Optical Film Thickness | Luminance Ratio | CIEx | CIEy | MaxΔu'v' |
|---|---|---|---|---|---|---|---|---|
| B0 | None (Air) | 1 | 0 | 0.000 | 1.000 | 0.110 | 0.188 | 0.155 |
| B1 | NPD | 1.915 | 10 | 19.150 | 1.087 | 0.112 | 0.191 | 0.158 |
| B2 | | | 20 | 38.300 | 1.169 | 0.117 | 0.184 | 0.148 |
| B3 | | | 30 | 57.450 | 1.220 | 0.122 | 0.166 | 0.118 |
| B4 | | | 40 | 76.600 | 1.220 | 0.127 | 0.144 | 0.080 |
| B5 | | | 50 | 95.750 | 1.171 | 0.128 | 0.129 | 0.060 |
| B6 | | | 60 | 114.900 | 1.090 | 0.126 | 0.125 | 0.067 |
| B7 | | | 70 | 134.050 | 1.002 | 0.123 | 0.129 | 0.081 |
| B8 | | | 80 | 153.200 | 0.926 | 0.119 | 0.136 | 0.096 |
| B9 | | | 90 | 172.350 | 0.872 | 0.116 | 0.145 | 0.107 |
| B10 | | | 100 | 191.500 | 0.844 | 0.113 | 0.154 | 0.119 |

(continued)

| Configuration Example No. | Optical Adjustment Layer | Refractive Index at 450 nm | Actual Film Thickness | Optical Film Thickness | Luminance Ratio | CIEx | CIEy | MaxΔu'v' |
|---|---|---|---|---|---|---|---|---|
| B11 | MgF | 1.330 | 10 | 13.300 | 1.029 | 0.111 | 0.190 | 0.159 |
| B12 | | | 20 | 26.600 | 1.063 | 0.112 | 0.190 | 0.159 |
| B13 | | | 30 | 39.900 | 1.096 | 0.113 | 0.187 | 0.156 |
| B14 | | | 40 | 53.200 | 1.125 | 0.114 | 0.182 | 0.150 |
| B15 | | | 50 | 66.500 | 1.146 | 0.116 | 0.176 | 0.144 |
| B16 | | | 60 | 79.800 | 1.155 | 0.117 | 0.170 | 0.135 |
| B17 | | | 70 | 93.100 | 1.151 | 0.118 | 0.164 | 0.126 |
| B18 | | | 80 | 106.400 | 1.135 | 0.118 | 0.161 | 0.121 |
| B19 | | | 90 | 119.700 | 1.109 | 0.118 | 0.159 | 0.117 |
| B20 | | | 100 | 133.000 | 1.076 | 0.117 | 0.160 | 0.118 |
| B21 | SiO | 2.078 | 10 | 20.780 | 1.093 | 0.113 | 0.192 | 0.217 |
| B22 | | | 20 | 41.560 | 1.161 | 0.119 | 0.181 | 0.194 |
| B23 | | | 30 | 62.340 | 1.164 | 0.126 | 0.157 | 0.138 |
| B24 | | | 40 | 83.120 | 1.098 | 0.129 | 0.134 | 0.056 |
| B25 | | | 50 | 103.900 | 1.009 | 0.128 | 0.123 | 0.055 |
| B26 | | | 60 | 124.680 | 0.895 | 0.125 | 0.124 | 0.070 |
| B27 | | | 70 | 145.460 | 0.812 | 0.121 | 0.131 | 0.086 |
| B28 | | | 80 | 166.240 | 0.757 | 0.117 | 0.141 | 0.102 |
| B29 | | | 90 | 187.020 | 0.731 | 0.114 | 0.151 | 0.113 |
| B30 | | | 100 | 207.800 | 0.733 | 0.112 | 0.161 | 0.123 |
| B31 | TiO$_2$ | 2.339 | 10 | 23.391 | 1.131 | 0.114 | 0.192 | 0.154 |
| B32 | | | 20 | 46.782 | 1.204 | 0.123 | 0.171 | 0.116 |
| B33 | | | 30 | 70.174 | 1.163 | 0.131 | 0.133 | 0.053 |
| B34 | | | 40 | 93.565 | 1.048 | 0.133 | 0.110 | 0.041 |
| B35 | | | 50 | 116.956 | 0.920 | 0.129 | 0.107 | 0.058 |
| B36 | | | 60 | 140.347 | 0.816 | 0.124 | 0.115 | 0.069 |
| B37 | | | 70 | 163.738 | 0.750 | 0.119 | 0.127 | 0.097 |
| B38 | | | 80 | 187.130 | 0.727 | 0.115 | 0.140 | 0.113 |
| B39 | | | 90 | 210.521 | 0.745 | 0.113 | 0.151 | 0.124 |
| B40 | | | 100 | 233.912 | 0.803 | 0.113 | 0.158 | 0.133 |

[Table 2]

| Configuration Example No. | Optical Adjustment Layer | Refractive Index at 450 nm | Actual Film Thickness | Optical Film Thickness | Luminance Ratio | CIEx | CIEy | MaxΔu'v' |
|---|---|---|---|---|---|---|---|---|
| B41 | WO$_3$ | 2.138 | 10 | 21.380 | 1.116 | 0.114 | 0.184 | 0.206 |
| B42 | | | 20 | 42.760 | 1.208 | 0.121 | 0.174 | 0.194 |
| B43 | | | 30 | 64.140 | 1.213 | 0.128 | 0.147 | 0.123 |
| B44 | | | 40 | 85.520 | 1.134 | 0.132 | 0.120 | 0.037 |
| B45 | | | 50 | 106.900 | 1.019 | 0.131 | 0.109 | 0.043 |
| B46 | | | 60 | 128.280 | 0.910 | 0.127 | 0.110 | 0.059 |
| B47 | | | 70 | 149.660 | 0.828 | 0.123 | 0.118 | 0.086 |
| B48 | | | 80 | 171.040 | 0.795 | 0.117 | 0.136 | 0.105 |
| B49 | | | 90 | 192.420 | 0.782 | 0.114 | 0.148 | 0.119 |
| B50 | | | 100 | 213.800 | 0.804 | 0.112 | 0.158 | 0.129 |
| B51 | ZnS | 2.470 | 10 | 24.698 | 1.163 | 0.115 | 0.194 | 0.221 |
| B52 | | | 20 | 49.396 | 1.231 | 0.126 | 0.166 | 0.163 |
| B53 | | | 30 | 74.094 | 1.140 | 0.134 | 0.121 | 0.032 |
| B54 | | | 40 | 98.792 | 1.028 | 0.134 | 0.101 | 0.039 |
| B55 | | | 50 | 123.490 | 0.851 | 0.129 | 0.103 | 0.061 |
| B56 | | | 60 | 148.188 | 0.758 | 0.123 | 0.114 | 0.082 |
| B57 | | | 70 | 172.886 | 0.716 | 0.118 | 0.128 | 0.102 |
| B58 | | | 80 | 197.584 | 0.725 | 0.114 | 0.143 | 0.118 |
| B59 | | | 90 | 222.282 | 0.786 | 0.112 | 0.155 | 0.131 |
| B60 | | | 100 | 246.980 | 0.897 | 0.114 | 0.160 | 0.139 |

[Table 3]

| Configuration Example No. | Optical Adjustment Layer | Refractive Index at 450 nm | Actual Film Thickness | Optical Film Thickness | Luminance Ratio | CIEx | CIEy | MaxΔu'v' |
|---|---|---|---|---|---|---|---|---|
| G0 | None (Air) | 1 | 0 | 0.000 | 1.000 | 0.266 | 0.691 | 0.032 |
| G1 | NPD | 1.915 | 10 | 19.150 | 1.037 | 0.273 | 0.684 | 0.036 |
| G2 | | | 20 | 38.300 | 1.084 | 0.276 | 0.677 | 0.038 |
| G3 | | | 30 | 57.450 | 1.132 | 0.275 | 0.671 | 0.038 |
| G4 | | | 40 | 76.600 | 1.176 | 0.268 | 0.671 | 0.033 |
| G5 | | | 50 | 95.750 | 1.212 | 0.256 | 0.677 | 0.024 |
| G6 | | | 60 | 114.900 | 1.233 | 0.242 | 0.688 | 0.017 |
| G7 | | | 70 | 134.050 | 1.224 | 0.233 | 0.700 | 0.016 |
| G8 | | | 80 | 153.200 | 1.181 | 0.229 | 0.709 | 0.016 |
| G9 | | | 90 | 172.350 | 1.118 | 0.230 | 0.713 | 0.017 |
| G10 | | | 100 | 191.500 | 1.052 | 0.233 | 0.714 | 0.020 |

(continued)

| Configuration Example No. | Optical Adjustment Layer | Refractive Index at 450 nm | Actual Film Thickness | Optical Film Thickness | Luminance Ratio | CIEx | CIEy | MaxΔu'v' |
|---|---|---|---|---|---|---|---|---|
| G11 | MgF | 1.330 | 10 | 13.300 | 1.014 | 0.268 | 0.689 | 0.034 |
| G12 | | | 20 | 26.600 | 1.033 | 0.270 | 0.686 | 0.035 |
| G13 | | | 30 | 39.900 | 1.058 | 0.271 | 0.685 | 0.036 |
| G14 | | | 40 | 53.200 | 1.084 | 0.270 | 0.683 | 0.036 |
| G15 | | | 50 | 66.500 | 1.112 | 0.269 | 0.683 | 0.036 |
| G16 | | | 60 | 79.800 | 1.137 | 0.266 | 0.684 | 0.035 |
| G17 | | | 70 | 93.100 | 1.158 | 0.263 | 0.685 | 0.034 |
| G18 | | | 80 | 106.400 | 1.171 | 0.259 | 0.688 | 0.031 |
| G19 | | | 90 | 119.700 | 1.175 | 0.256 | 0.691 | 0.029 |
| G20 | | | 100 | 133.000 | 1.168 | 0.254 | 0.694 | 0.027 |
| G21 | SiO | 2.078 | 10 | 20.780 | 1.039 | 0.275 | 0.681 | 0.036 |
| G22 | | | 20 | 41.560 | 1.082 | 0.279 | 0.672 | 0.039 |
| G23 | | | 30 | 62.340 | 1.117 | 0.275 | 0.667 | 0.035 |
| G24 | | | 40 | 83.120 | 1.143 | 0.262 | 0.671 | 0.025 |
| G25 | | | 50 | 103.900 | 1.159 | 0.243 | 0.683 | 0.015 |
| G26 | | | 60 | 124.680 | 1.149 | 0.229 | 0.699 | 0.014 |
| G27 | | | 70 | 145.460 | 1.102 | 0.223 | 0.711 | 0.015 |
| G28 | | | 80 | 166.240 | 1.032 | 0.224 | 0.717 | 0.016 |
| G29 | | | 90 | 187.020 | 0.963 | 0.229 | 0.718 | 0.019 |
| G30 | | | 100 | 207.800 | 0.909 | 0.235 | 0.715 | 0.022 |
| G31 | TiO$_2$ | 2.339 | 10 | 23.391 | 1.049 | 0.277 | 0.678 | 0.037 |
| G32 | | | 20 | 46.782 | 1.090 | 0.280 | 0.666 | 0.039 |
| G33 | | | 30 | 70.174 | 1.114 | 0.269 | 0.662 | 0.030 |
| G34 | | | 40 | 93.565 | 1.135 | 0.245 | 0.673 | 0.015 |
| G35 | | | 50 | 116.956 | 1.144 | 0.222 | 0.695 | 0.014 |
| G36 | | | 60 | 140.347 | 1.107 | 0.212 | 0.713 | 0.016 |
| G37 | | | 70 | 163.738 | 1.031 | 0.212 | 0.722 | 0.017 |
| G38 | | | 80 | 187.130 | 0.952 | 0.219 | 0.724 | 0.019 |
| G39 | | | 90 | 210.521 | 0.895 | 0.227 | 0.720 | 0.022 |
| G40 | | | 100 | 233.912 | 0.868 | 0.236 | 0.714 | 0.025 |

[Table 4]

| Configuration Example No. | Optical Adjustment Layer | Refractive Index at 450 nm | Actual Film Thickness | Optical Film Thickness | Luminance Ratio | CIEx | CIEy | MaxΔu'v' |
|---|---|---|---|---|---|---|---|---|
| G41 | W0$_3$ | 2.138 | 10 | 21.380 | 1.051 | 0.276 | 0.680 | 0.037 |
| G42 | | | 20 | 42.760 | 1.103 | 0.280 | 0.670 | 0.039 |
| G43 | | | 30 | 64.140 | 1.144 | 0.275 | 0.664 | 0.035 |
| G44 | | | 40 | 85.520 | 1.176 | 0.258 | 0.669 | 0.022 |
| G45 | | | 50 | 106.900 | 1.200 | 0.236 | 0.685 | 0.014 |
| G46 | | | 60 | 128.280 | 1.191 | 0.221 | 0.703 | 0.015 |
| G47 | | | 70 | 149.660 | 1.136 | 0.217 | 0.715 | 0.016 |
| G48 | | | 80 | 171.040 | 1.059 | 0.220 | 0.720 | 0.017 |
| G49 | | | 90 | 192.420 | 0.989 | 0.226 | 0.720 | 0.020 |
| G50 | | | 100 | 213.800 | 0.940 | 0.233 | 0.716 | 0.023 |
| G51 | ZnS | 2.470 | 10 | 24.698 | 1.066 | 0.280 | 0.675 | 0.038 |
| G52 | | | 20 | 49.396 | 1.111 | 0.283 | 0.660 | 0.039 |
| G53 | | | 30 | 74.094 | 1.126 | 0.265 | 0.658 | 0.023 |
| G54 | | | 40 | 98.792 | 1.146 | 0.232 | 0.677 | 0.012 |
| G55 | | | 50 | 123.490 | 1.143 | 0.209 | 0.705 | 0.017 |
| G56 | | | 60 | 148.188 | 1.080 | 0.204 | 0.722 | 0.017 |
| G57 | | | 70 | 172.886 | 0.993 | 0.209 | 0.728 | 0.018 |
| G58 | | | 80 | 197.584 | 0.925 | 0.219 | 0.726 | 0.021 |
| G59 | | | 90 | 222.282 | 0.893 | 0.229 | 0.719 | 0.024 |
| G60 | | | 100 | 246.980 | 0.900 | 0.240 | 0.709 | 0.028 |

[Table 5]

| Configuration Example No. | Optical Adjustment Layer | Refractive Index at 450 nm | Actual Film Thickness | Optical Film Thickness | Luminance Ratio | CIEx | CIEy | MaxΔu'v' |
|---|---|---|---|---|---|---|---|---|
| R0 | None (Air) | 1 | 0 | 0.000 | 1.000 | 0.644 | 0.354 | 0.008 |
| R1 | NPD | 1.915 | 10 | 19.150 | 1.105 | 0.647 | 0.352 | 0.011 |
| R2 | | | 20 | 38.300 | 1.218 | 0.649 | 0.349 | 0.014 |
| R3 | | | 30 | 57.450 | 1.317 | 0.651 | 0.347 | 0.019 |
| R4 | | | 40 | 76.600 | 1.371 | 0.653 | 0.345 | 0.022 |
| R5 | | | 50 | 95.750 | 1.358 | 0.654 | 0.344 | 0.023 |
| R6 | | | 60 | 114.900 | 1.282 | 0.653 | 0.345 | 0.017 |
| R7 | | | 70 | 134.050 | 1.170 | 0.651 | 0.347 | 0.008 |
| R8 | | | 80 | 153.200 | 1.055 | 0.649 | 0.350 | 0.004 |
| R9 | | | 90 | 172.350 | 0.955 | 0.646 | 0.353 | 0.004 |
| R10 | | | 100 | 191.500 | 0.878 | 0.643 | 0.356 | 0.006 |

(continued)

| Configuration Example No. | Optical Adjustment Layer | Refractive Index at 450 nm | Actual Film Thickness | Optical Film Thickness | Luminance Ratio | CIEx | CIEy | Max△u'v' |
|---|---|---|---|---|---|---|---|---|
| R11 | MgF | 1.330 | 10 | 13.300 | 1.037 | 0.645 | 0.353 | 0.010 |
| R12 | | | 20 | 26.600 | 1.078 | 0.646 | 0.353 | 0.010 |
| R13 | | | 30 | 39.900 | 1.120 | 0.647 | 0.352 | 0.012 |
| R14 | | | 40 | 53.200 | 1.159 | 0.648 | 0.351 | 0.014 |
| R15 | | | 50 | 66.500 | 1.192 | 0.648 | 0.350 | 0.016 |
| R16 | | | 60 | 79.800 | 1.214 | 0.649 | 0.350 | 0.017 |
| R17 | | | 70 | 93.100 | 1.223 | 0.649 | 0.349 | 0.018 |
| R18 | | | 80 | 106.400 | 1.216 | 0.649 | 0.350 | 0.017 |
| R19 | | | 90 | 119.700 | 1.195 | 0.649 | 0.350 | 0.017 |
| R20 | | | 100 | 133.000 | 1.163 | 0.648 | 0.351 | 0.015 |
| R21 | SiO | 2.078 | 10 | 20.780 | 1.137 | 0.648 | 0.351 | 0.012 |
| R22 | | | 20 | 41.560 | 1.277 | 0.651 | 0.347 | 0.016 |
| R23 | | | 30 | 62.340 | 1.374 | 0.654 | 0.344 | 0.021 |
| R24 | | | 40 | 83.120 | 1.379 | 0.656 | 0.342 | 0.023 |
| R25 | | | 50 | 103.900 | 1.283 | 0.656 | 0.343 | 0.015 |
| R26 | | | 60 | 124.680 | 1.134 | 0.653 | 0.345 | 0.005 |
| R27 | | | 70 | 145.460 | 0.987 | 0.650 | 0.349 | 0.004 |
| R28 | | | 80 | 166.240 | 0.869 | 0.646 | 0.353 | 0.006 |
| R29 | | | 90 | 187.020 | 0.787 | 0.643 | 0.356 | 0.008 |
| R30 | | | 100 | 207.800 | 0.738 | 0.640 | 0.358 | 0.011 |
| R31 | TiO$_2$ | 2.339 | 10 | 23.391 | 1.170 | 0.649 | 0.350 | 0.013 |
| R32 | | | 20 | 46.782 | 1.323 | 0.653 | 0.345 | 0.020 |
| R33 | | | 30 | 70.174 | 1.376 | 0.656 | 0.342 | 0.025 |
| R34 | | | 40 | 93.565 | 1.283 | 0.657 | 0.341 | 0.020 |
| R35 | | | 50 | 116.956 | 1.101 | 0.654 | 0.344 | 0.008 |
| R36 | | | 60 | 140.347 | 0.923 | 0.650 | 0.349 | 0.004 |
| R37 | | | 70 | 163.738 | 0.789 | 0.645 | 0.354 | 0.006 |
| R38 | | | 80 | 187.130 | 0.702 | 0.641 | 0.358 | 0.008 |
| R39 | | | 90 | 210.521 | 0.656 | 0.638 | 0.360 | 0.010 |
| R40 | | | 100 | 233.912 | 0.643 | 0.636 | 0.362 | 0.011 |

[Table 6]

| Configuration Example No. | Optical Adjustment Layer | Refractive Index at 450 nm | Actual Film Thickness | Optical Film Thickness | Luminance Ratio | CIEx | CIEy | Max$\Delta$u'v' |
|---|---|---|---|---|---|---|---|---|
| R41 | | | 10 | 21.380 | 1.158 | 0.648 | 0.351 | 0.011 |
| R42 | | | 20 | 42.760 | 1.319 | 0.652 | 0.346 | 0.019 |
| R43 | | | 30 | 64.140 | 1.423 | 0.655 | 0.343 | 0.024 |
| R44 | | | 40 | 85.520 | 1.407 | 0.656 | 0.341 | 0.023 |
| R45 | $WO_3$ | 2.138 | 50 | 106.900 | 1.277 | 0.656 | 0.342 | 0.014 |
| R46 | | | 60 | 128.280 | 1.103 | 0.652 | 0.346 | 0.004 |
| R47 | | | 70 | 149.660 | 0.948 | 0.648 | 0.350 | 0.004 |
| R48 | | | 80 | 171.040 | 0.833 | 0.644 | 0.355 | 0.007 |
| R49 | | | 90 | 192.420 | 0.760 | 0.641 | 0.358 | 0.009 |
| R50 | | | 100 | 213.800 | 0.722 | 0.638 | 0.360 | 0.011 |
| R51 | | | 10 | 24.698 | 1.226 | 0.650 | 0.349 | 0.013 |
| R52 | | | 20 | 49.396 | 1.425 | 0.655 | 0.343 | 0.022 |
| R53 | | | 30 | 74.094 | 1.452 | 0.658 | 0.339 | 0.025 |
| R54 | | | 40 | 98.792 | 1.268 | 0.658 | 0.340 | 0.012 |
| R55 | ZnS | 2.470 | 50 | 123.490 | 1.021 | 0.653 | 0.345 | 0.004 |
| R56 | | | 60 | 148.188 | 0.829 | 0.647 | 0.351 | 0.006 |
| R57 | | | 70 | 172.886 | 0.710 | 0.642 | 0.357 | 0.010 |
| R58 | | | 80 | 197.584 | 0.647 | 0.638 | 0.361 | 0.012 |
| R59 | | | 90 | 222.282 | 0.631 | 0.635 | 0.363 | 0.012 |
| R60 | | | 100 | 246.980 | 0.655 | 0.634 | 0.363 | 0.012 |

As shown in FIG. 5, values of Max$\Delta$u'v' vary depending on the actual film thicknesses of the optical adjustment layers, and when the actual film thickness is in a range of 30 nm to 90 nm in any one of all of the optical adjustment layers, a value of Max$\Delta$u'v' is the minimum value. That is, by limiting the actual film thickness of the optical adjustment layer in a predetermined range, it can be seen that a color change can be suppressed to the minimum.

Refractive indices of the respective optical adjustment layers are as follows: MgF: 1.33; NPD: 1.915; SiO: 2.078; $WO_3$: 2.138; ZnS: 2.4698; and $TiO_2$: 2.339. The actual film thickness of the MgF optical adjustment layer in which a value of Max$\Delta$u'v' is the minimum value is 90 nm, the actual film thickness of the NPD optical adjustment layer in which a value of Max$\Delta$u'v' is the minimum value is 50 nm, the actual film thickness of the SiO optical adjustment layer in which a value of Max$\Delta$u'v' is the minimum value is 50 nm, the actual film thickness of the $WO_3$ optical adjustment layer in which a value of Max$\Delta$u'v' is the minimum value is 40 nm, the actual film thickness of the ZnS optical adjustment layer in which a value of Max$\Delta$u'v' is the minimum value is 30 nm, and the actual film thickness of the $TiO_2$ optical adjustment layer in which a value of Max$\Delta$u'v' is the minimum value is 40 nm.

From the above description, it can be seen that the greater the refractive index, the smaller the value of the actual film thickness in which a value of Max$\Delta$u'v' is the minimum value. Therefore, it can be seen that, when an evaluation is performed on the basis of the optical film thickness, which is a product of the refractive index and the actual film thickness of the optical adjustment layer, the optical film thicknesses of the optical adjustment layers in which a value of Max$\Delta$u'v' is the minimum value are approximately constant, irrespective of the materials of the optical adjustment layers. In addition, in the case of MgF having the minimum refractive index, a value of MaxOu'v' is not changed greatly even when the actual film thickness of the optical adjustment layer is changed, and thus it can be seen that, in order to suppress a color change in the wide-angle direction, it is preferable that the refractive index of the optical adjustment layer be more than 1.33.

As described above, the viewing angle characteristics of the organic EL element vary depending on the refractive index and the optical film thickness of the optical adjustment layer, and the greater the refractive index of the optical adjustment layer, the smaller the color change in the wide-angle direction. The effect of suppressing color using the optical adjustment layer is not determined by only an optical film thickness of the optical adjustment layer. Unless the optical adjustment layer has a refractive index of not less than a predetermined refractive index, such an effect is not exhibited sufficiently. That is, unless both of a refractive index and an optical film thickness of the optical adjustment layer are designed appropriately, a color change in the wide-angle direction is not suppressed, and even if suppressed, the effect is limited.

As clearly seen from FIG. 5, in order to obtain the effect of suppressing color using the optical adjustment layer, as the optical adjustment, one having a refractive index of not less than 1.915 may be used. In addition, according to Tables 1 to 6, in order to suppress a change of observed light sufficiently, the optical film thickness, which is a product of the refractive index and the actual film thickness of the optical adjustment layer, may be not less than 70.174 nm and not more than 140.347 nm.

Here, "a color change is suppressed" means that a value of Max$\Delta$u'v' is not more than 0.081. If a value of Max$\Delta$u'v' falls within this range, practically sufficient viewing angle characteristics can be obtained even in a case where, for example, an organic EL element is formed for each pixel to form a full-color organic EL display.

According to Tables 1 and 2, in Configuration Examples B4 to B7, B24 to B26, B33 to B36, B44 to B46, and B53 to B55, all the optical film thicknesses are not less than 70.174 nm and not more than 140.347 nm and all the values of Max$\Delta$u'v' are not more than 0.081. In addition, according to Tables 3 to 6, all the values of Max$\Delta$u'v' are not more than 0.039 in Configuration Examples G1 to G60 and R1 to R60, and a color change in the wide-angle direction is barely generated. Accordingly, it can be seen that a color change of blue light is the most important issue and that, if this color change is suppressed, practically sufficient viewing angle characteristics can be obtained even with the strictest evaluation criteria required for an organic EL display and the like.

It is preferable that the refractive index of the optical adjustment layer be not less than 2.078. According to Table 1, by setting the refractive index of the optical adjustment layer to be not less than 2.078, a value of Max$\Delta$u'v' can be set to be not more than 0.07. For example, in any one of Configuration Examples B24 to B26, B33 to B36, B44 to B46, and B53 to B55 which are shown in Table 1, All the refractive indices are not less than 2.078 and all the values of Max$\Delta$u'v' are not more than 0.07. With this configuration, an organic EL element with further less color change can be provided.

More preferably, when the refractive index is not less than 2.078 and the optical film thickness is not less than 74.094 nm and not more than 123.49 nm, a value of Max$\Delta$u'v' can be set to be not more than 0.061. For example, in Configuration Examples B24 to B25, B34 to B35, B44 to B45, and B53 to B55, all the optical film thicknesses are not less than 74.094 nm and not more than 123.49 nm, and thus all the values of Max$\Delta$u'v' are not more than 0.061. With this configuration, an organic EL element with further less color change can be provided.

As described above, according to the organic EL element 1 of the present invention, an organic EL element in which a color change over a wide range of viewing angles is reduced without using a color filter can be provided. Therefore, as compared to a structure of Patent Document 1 using a color filter, a bright display can be realized with less power consumption. In addition, when a color filter is used, a high-level bonding process is necessary in which the color filter is bonded while aligning the color filter with the position of an organic EL element. On the other hand, in the present invention, the optical adjustment layer 19 can be formed along with a process of forming the organic EL element 1 by, for example, continuously forming the second electrode 18 and the optical adjustment layer 19 in the same film-forming apparatus. Accordingly, a process is simple and manufacturing is easy. Therefore, the small and inexpensive organic EL element 1 and the organic EL panel 100 which have excellent color reproduction over a wide range of viewing angles can be provided.

Various devices such as organic EL devices or organic EL light devices can be applied to the above-described organic EL element 1. For example, single or multiple organic EL elements 1 are disposed on the substrate 10; and optical distances between reflective layers and optical adjustment layers of the respective organic EL elements 1 are adjusted to be the same. As a result, an organic EL light device which emits single-color illumination light can be provided. In addition, three kinds of pixels which respectively emit red light, green light, and blue light are disposed on the substrate 10 in a matrix; and optical distances between reflective layers and optical adjustment layers of organic EL elements which are formed for red pixels, green pixels, and blue pixels are designed such that red light, green light, and blue light are respectively amplified. As a result, an organic EL display in which full-color display is possible can be provided.

When an organic EL display is manufactured, it is preferable that light-emitting layers of organic EL elements which are formed for red pixels, green pixels, and blue pixels be formed by only the red light-emitting material, the green light-emitting material, and the blue light-emitting material, respectively. As a result, the usage efficiency of light emitted from the light-emitting layers can be improved. In addition, it is preferable that all the actual film thicknesses of the optical adjustment layers be the same in the organic EL elements which emit the respective color light rays. As a result, an organic EL panel with less color unevenness can be provided, and since organic adjustment layers can be formed in respective organic EL elements through a common process, manufacturing processes are simplified.

Industrial Applicability

The present invention provides a novel organic EL element, which is industrially applicable.

**Claims**

1. An organic EL element having a reflective layer, a first electrode, a light-emitting layer, a second electrode, and a semi-transparent reflective layer disposed in that order, wherein said semi-transparent reflective layer comprises an optical adjustment layer formed of an insulating material which is provided so as to contact said second electrode on an opposite side from said light-emitting layer, and said optical adjustment layer has a refractive index at a wavelength of 450 nm of not less than 1.915, and has an optical film thickness, calculated as an arithmetic product of said refractive index and a film thickness, of not less than 70.174 nm and not more than 140.347 nm.

2. The organic EL element according to Claim 1, wherein the refractive index of said optical adjustment layer is not less than 2.078.

3. The organic EL element according to Claim 2, wherein an optical film thickness of said optical adjustment layer is not more than 123.49 nm.

4. The organic EL element according to Claim 1, wherein said optical adjustment layer is formed of one material selected from the group consisting of silicon monoxide (SiO), tungsten oxide ($WO_3$), zinc sulfide (ZnS), N,N'-bis (naphthalen-1-yl)-N,N'-bis(phenyl)-benzidine and titanium dioxide ($TiO_2$).

5. The organic EL element according to Claim 1, wherein an optical distance between said reflective layer and said semi-transparent reflective layer is set so as to possess a resonance wavelength in a blue light wavelength region.

6. The organic EL element according to Claim 5, wherein said light-emitting layer is formed of a blue light-emitting material.

7. An organic EL panel, comprising a plurality of the organic EL element according to Claim 1 aligned on a substrate.

8. An organic EL panel, comprising a plurality of the organic EL element according to Claim 6 aligned on a substrate.

9. An organic EL panel according to Claim 7, wherein a plurality of organic EL elements which emit light of mutually different colors from respective said semi-transparent reflective layers are provided on said substrate, and refractive indices and optical film thicknesses of said optical adjustment layers of said plurality of organic EL elements are equal.

# FIG. 1

100

| | |
|---|---|
| OPTICAL ADJUSTMENT LAYER | ~19 |
| SECOND ELECTRODE | ~18 |
| ELECTRON INJECTION LAYER | ~17 |
| ELECTRON TRANSPORT LAYER | ~16 |
| LIGHT-EMITTING LAYER | ~15 |
| HOLE TRANSPORT LAYER | ~14 |
| HOLE INJECTION LAYER | ~13 |
| FIRST ELECTRODE | ~12 |
| REFLECTIVE LAYER | ~11 |
| SUBSTRATE | ~10 |

1

# FIG. 2

# FIG. 3

# FIG. 4

# FIG. 5

## INTERNATIONAL SEARCH REPORT

| International application No. |
| --- |
| PCT/JP2010/073515 |

A.  CLASSIFICATION OF SUBJECT MATTER
*H05B33/24*(2006.01)i, *G09F9/30*(2006.01)i, *H01L27/32*(2006.01)i, *H01L51/50*(2006.01)i

According to International Patent Classification (IPC) or to both national classification and IPC

B.  FIELDS SEARCHED

Minimum documentation searched (classification system followed by classification symbols)
H05B33/24, G09F9/30, H01L27/32, H01L51/50

Documentation searched other than minimum documentation to the extent that such documents are included in the fields searched
| | | | |
| --- | --- | --- | --- |
| Jitsuyo Shinan Koho | 1922–1996 | Jitsuyo Shinan Toroku Koho | 1996–2011 |
| Kokai Jitsuyo Shinan Koho | 1971–2011 | Toroku Jitsuyo Shinan Koho | 1994–2011 |

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
| --- | --- | --- |
| X<br>Y | JP 2008-210665 A  (Canon Inc.),<br>11 September 2008 (11.09.2008),<br>paragraphs [0034] to [0069], [0097] to [0099];<br>chemical formulae 2, 3; fig. 1 to 4, 8<br>& US 2008/0203908 A1 | 1,5-9<br>2,3 |
| Y | JP 2009-259721 A  (Hitachi Displays, Ltd.),<br>05 November 2009 (05.11.2009),<br>paragraph [0057]<br>(Family: none) | 2,3 |
| A | JP 2008-218081 A  (Canon Inc.),<br>18 September 2008 (18.09.2008),<br>paragraphs [0013] to [0046]; fig. 4<br>(Family: none) | 1-3,5-9 |

| ☒ | Further documents are listed in the continuation of Box C. | ☐ | See patent family annex. |
| --- | --- | --- | --- |

\*    Special categories of cited documents:
"A"    document defining the general state of the art which is not considered to be of particular relevance
"E"    earlier application or patent but published on or after the international filing date
"L"    document which may throw doubts on priority claim(s) or which is cited to establish the publication date of another citation or other special reason (as specified)
"O"    document referring to an oral disclosure, use, exhibition or other means
"P"    document published prior to the international filing date but later than the priority date claimed

"T"    later document published after the international filing date or priority date and not in conflict with the application but cited to understand the principle or theory underlying the invention
"X"    document of particular relevance; the claimed invention cannot be considered novel or cannot be considered to involve an inventive step when the document is taken alone
"Y"    document of particular relevance; the claimed invention cannot be considered to involve an inventive step when the document is combined with one or more other such documents, such combination being obvious to a person skilled in the art
"&"    document member of the same patent family

| Date of the actual completion of the international search<br>  02 March, 2011 (02.03.11) | Date of mailing of the international search report<br>  15 March, 2011 (15.03.11) |
| --- | --- |
| Name and mailing address of the ISA/<br>  Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2010/073515

C (Continuation). DOCUMENTS CONSIDERED TO BE RELEVANT

| Category* | Citation of document, with indication, where appropriate, of the relevant passages | Relevant to claim No. |
|---|---|---|
| A | JP 2009-187748 A (Toshiba Mobile Display Co., Ltd.), 20 August 2009 (20.08.2009), paragraphs [0037] to [0056]; fig. 3 (Family: none) | 1-3,5-9 |
| A | JP 2009-054493 A (Panasonic Electric Works Co., Ltd.), 12 March 2009 (12.03.2009), paragraphs [0023] to [0074]; fig. 1 & EP 2190265 A1      & WO 2009/028620 A1 & KR 10-2010-0063730 A   & CN 101843172 A | 1-3,5-9 |
| A | JP 2004-111398 A (Samsung NEC Mobile Display Co., Ltd.), 08 April 2004 (08.04.2004), paragraphs [0028] to [0063] & US 2004/0056590 A1     & EP 1401034 A2 & KR 10-2004-0025025 A   & CN 1496206 A | 1-3,5-9 |
| A | JP 2005-129510 A (Sanyo Electric Co., Ltd.), 19 May 2005 (19.05.2005), paragraph [0051]; fig. 7 & US 2005/0073230 A1     & US 2008/0297043 A1 & TW 249149 B            & KR 10-2005-0031922 A & KR 10-2006-0125652 A   & CN 1604708 A | 1-3,5-9 |

Form PCT/ISA/210 (continuation of second sheet) (July 2009)

**INTERNATIONAL SEARCH REPORT**

International application No.

PCT/JP2010/073515

| Box No. II | Observations where certain claims were found unsearchable (Continuation of item 2 of first sheet) |
|---|---|

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

| Box No. III | Observations where unity of invention is lacking (Continuation of item 3 of first sheet) |
|---|---|

This International Searching Authority found multiple inventions in this international application, as follows:

```
    [First invention group]: the inventions in claim 1, and claims 2, 3 and
claims 5 - 9

    [Second invention group]: the invention in claim 4

                                              (continued to extra sheet)
```

1. ☐ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☒ No required additional search fees were timely paid by the applicant. Consequently, this international search report is restricted to the invention first mentioned in the claims; it is covered by claims Nos.: 1 - 3, 5 - 9

**Remark on Protest**
☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

**INTERNATIONAL SEARCH REPORT**

International application No.

PCT/JP2010/073515

Continuation of Box No.III of continuation of first sheet(2)

Meanwhile, the inventions in claims 5, 6 having no special technical feature are classified into the first invention group, and the inventions in claims 7 - 9 are also classified into the first invention group since the inventions in claims 7 - 9 are mere addition of a well known art onto the invention in claim 1 and do not exhibit any new effect.

Form PCT/ISA/210 (extra sheet) (July 2009)

**EP 2 521 424 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009297240 A

- JP 2005129510 A

**Non-patent literature cited in the description**

- From the Basics to the Frontiers in the Research of Organic EL Materials and Devices. *Japan Society of Applied Physics, Molecular Electronics and Bioelectronics Division, JSAP Catalog Number: AP93 2376,* 16 December 1993, 135-143